# EUROPÄISCHE PATENTSCHRIFT

(11) **EP 1 362 503 B1**
(45) Veröffentlichungstag und Bekanntmachung des Hinweises auf die Patenterteilung: **27.12.2006**
(21) Anmeldenummer: 02710832.3
(22) Anmeldetag: 02.02.2002
(51) Int. Cl.: H05K 7/20

(54) **ELEKTRONISCHE BAUGRUPPE**
ELECTRONIC MODULE
MODULE ELECTRONIQUE

(30) Priorität: 24.02.2001 DE 10109083
(43) Veröffentlichungstag der Anmeldung: 19.11.2003
(73) Patentinhaber: Conti Temic microelectronic GmbH, 90411 Nürnberg (DE)
(72) Erfinder: BERGHOFF, Gerhard, 85077 Manching (DE); HEINZ, Helmut, 91522 Ansbach (DE); KOLBINGER, Martin, 93339 Riedenburg/Buch (DE); NEHMEIER, Friedrich, 91056 Erlangen (DE); SCHNEIDER, Johann, 85139 Wettstetten (DE); SCHUCH, Bernhard, 91616 Neusitz (DE); TRAGESER, Hubert, 90409 Nürnberg (DE); WALDAU, Ireneus, 85111 Adelschlag (DE)
(86) Internationale Anmeldenummer: PCT/EP2002/001090
(87) Internationale Veröffentlichungsnummer: WO 2002/069685

(56) Entgegenhaltungen:
- DE-A- 3 932 213
- DE-A- 4 416 403
- US-A- 5 834 336

## Beschreibung

In vielen Anwendungsbereichen werden elektronische Baugruppen eingesetzt, bei deren Betrieb eine hohe Verlustleistung auftritt; insbesondere ist dies bei elektronischen Baugruppen mit Leistungsbauteilen der Fall, wie bsp. bei Leistungsmodulen zur Ansteuerung elektronischer Komponenten oder weiterer Baugruppen. Die Bauteile der elektronischen Baugruppe werden auf einen geeigneten Trägerkörper aufgebracht (bsp. auf die Oberseite einer Leiterplatte); insbesondere werden bei Leistungsmodulen oftmals oberflächenmontierbare Leistungsbauteile verwendet, die mit ihrer rückseitigen Anschlußfläche auf dem Trägerkörper aufliegen. Zur Wärmeabfuhr der Verlustleistung der Bauteile (insbesondere der Verlustleistung von Leistungsbauteilen) wird der Trägerkörper auf einen metallischen Kühlkörper (bsp. eine Aluminiumplatte) aufgebracht, über den die Verlustleistung ggf. an ein Kühlsystem weitergeben kann.

Hierbei ist es aus der DE 198 42 590 A1 und der DE 199 09 505 A1 bekannt, den Trägerkörper über eine auf der Unterseite des Trägerkörpers aufgebrachte Isolationsfolie potentialmäßig vom Kühlkörper zu trennen. Nachteilig bei der Verwendung einer derartigen Isolationsfolie ist deren geringe Wärmeleitfähigkeit, die hohe Klebkraft (die miteinander verbundenen Teile Trägerkörper und Kühlkörper können nicht mehr zerstörungsfrei und rückstandsfrei demontiert werden), die geringen adhäsiven Eigenschaften (zur dauerhaften Verbindung von Trägerkörper und Kühlkörper sind somit zusätzliche Verbindungselemente erforderlich), der aufgrund der geringen Dicke der Isolationsfolie oftmals zu geringe Isolationsabstand für die elektrische Isolation und das unvollständig Ausfüllen von Unebenheiten (es verbleiben somit Hohlräume in den Verbindungsflächen).

Der Erfindung liegt die Aufgabe zugrunde, eine elektronische Baugruppe mit einem einfachen Aufbau, einem weiten Einsatzbereich und vorteilhaften Eigenschaften bezüglich der Wärmeabfuhr, der Zuverlässigkeit, der Kosten und des Herstellungsprozesses anzugeben.

Diese Aufgabe wird gemäß der Erfindung durch das Merkmal im Kennzeichen des Patentanspruchs 1 gelöst.

Vorteilhafte Ausgestaltungen der Erfindung sind Bestandteil der weiteren Patentansprüche.

Erfindungsgemäß ist zwischen dem mit einer Leitbahnstruktur (Leiterbahnen und Anschlußflächen) versehenen, zur Aufnahme der Bauteile der elektronischen Baugruppe vorgesehenen und dem Trägerkörper und dem Kühlkörper eine elektrisch isolierende, thermisch leitfähige und dauerhaft elastische Verbindungsschicht angeordnet, d.h. eine Verbindungsschicht mit einer hohen elektrischen Isolation, einem geringen thermischen Widerstand und einer hohen Flexibilität in einem weiten Temperaturbereich; die Verbindungsschicht besteht als "gefülltes" Polymer aus einem Materialgemisch einer vernetzten polymeren Grundsubstanz und mehreren Zuschlagssubstanzen und wird mittels zweier unterschiedlicher (flüssiger) Reaktionspartner aus unvernetzten Polymeren hergestellt; diese Verbindungsschicht bewirkt eine adhäsive, hohlraumfreie und wieder lösbare Fügeverbindung zwischen den beiden Fügeteilen (Fügepartnern) Trägerkörper und Kühlkörper, die somit in jeder Lage zusammengehalten werden und auf einfache Weise zerstörungsfrei und rückstandsfrei wieder getrennt werden können. Die beiden getrennt gelagerten (flüssigen) Reaktionspartner enthalten keine Gefahrstoffe und können gefahrlos bei Umgebungsbedingungen (bei Umgebungstemperatur) ohne Sicherheitsvorkehrungen aufbewahrt werden. Beide Reaktionspartner enthalten als Komponenten jeweils eine als unvernetztes Polymer ausgebildete Grundsubstanz (bsp. ein Silikon, ein Silan oder ein Polyurethan), der jeweils zwei Zuschlagssubstanzen zur Gewährleistung der gewünschten Eigenschaften der Verbindungsschicht (insbesondere der thermischen und elektrischen Eigenschaften der Verbindungsschicht) und jeweils eine dritte Zuschlagssubstanz zur Durchführung einer (Vernetzungs-)Reaktion in den beiden Reaktionspartnern beigemischt sind:
- als erste Zuschlagssubstanz sind zur Gewährleistung der Anforderungen hinsichtlich elektrischer Isolation und guter thermischer Anbindung der Verbindungsschicht elektrisch isolierende Partikel (Feststoffe) mit hoher Wärmeleitfähigkeit vorgesehen, bsp. ist die erste Zuschlagssubstanz ein Keramikpulver, bsp. aus Bornitrid oder aus einem Gemisch von Al₂O₃ und AlN; vorzugsweise ist in beiden Reaktionspartnern die selbe erste Zuschlagssubstanz (und damit eine erste Zuschlagssubstanz mit gleicher thermischer Leitfähigkeit) im gleichen Mengenverhältnis enthalten - bsp. enthält die Grundsubstanz beider Reaktionspartner als erste Zuschlagssubstanz elektrisch isolierende und thermisch leitfähige Partikel mit einem Anteil von jeweils 1 % bis 50% und einem Durchmesser von ≤ 30 µm.
- als zweite Zuschlagssubstanz sind zur Gewährleistung eines definierten elektrischen Isolationsabstands und damit zur Vermeidung eines direkten Kontakts (der Unterseite) des Trägerkörpers mit dem Kühlkörper als Abstandshalter fungierende, eine Mindestdicke der Verbindungsschicht gewährleistende, inkompressible Partikel (Feststoffe) vorgesehen, bsp. kugelförmige Partikel (bsp. Hohlkugeln oder Vollkugeln), bsp. aus Glas, Kunststoff oder Keramik; vorzugsweise ist in beiden Reaktionspartnern die selbe zweite Zuschlagssubstanz im gleichen Mengenverhältnis enthalten - bsp. enthält die Grundsubstanz beider Reaktionspartner als zweite Zuschlagssubstanz inkompressible Partikel mit einem Anteil von jeweils 0.5% bis 5% und einem größerem Durchmesser als der ersten Füllsubstanz, bsp. von ca. 150 µm.
- als dritte Zuschlagssubstanz ist zur Durchführung der Vernetzungsreaktion in den beiden Reaktionspartnern jeweils eine Reaktionssubstanz vorgesehen; hierzu ist im einen der beiden Reaktionspartner eine als Vernetzersubstanz fungierende Reaktionssubstanz enthalten (diese bewirkt eine dreidimensionale Vernetzungsreaktion des unvernetzten Polymers der Grundsubstanz), bsp. ein wasserstoffhaltiger Vernetzer, und im anderen der beiden Reaktionspartner eine als Katalysator zur Aktivierung und zur Beschleunigung der Vernetzungsreaktion fungierende Reaktionssubstanz, bsp. ein Platinkatalysator. Bsp. enthält die Grundsubstanz des einen der beiden Reaktionspartner einen wasserstoffhaltigen Vernetzer als Vernetzersubstanz mit einem Anteil von 0.1 % bis 5% und die Grundsubstanz des anderen der beiden Reaktionspartner Partikel eines Platinkatalysators als Spurenanteil.

Vor dem Fügen der beiden Fügepartner Trägerkörper und Kühlkörper werden die beiden getrennt gelagerten, in flüssigem Zustand vorliegenden Reaktionspartner zusammengebracht (bsp. zusammengerührt oder in einem statischen Mischrohr vermischt), wodurch eine Reaktion in beiden Reaktionspartnern ausgelöst wird; insbesondere wird beim Kontakt der beiden Reaktionssubstanzen, d.h. des Katalysators im einen Reaktionspartner mit der Vernetzersubstanz im anderen Reaktionspartner eine dreidimensionale (räumliche) Vernetzungsreaktion des unvernetzten Polymers der Grundsubstanz durchgeführt (bsp. eine Polyaddition als Additionsvernetzung); die beiden Reaktionspartner reagieren dabei miteinander, ohne daß bei der Vernetzungsreaktion (bsp. der Polyaddition) Spaltprodukte entstehen, insbesondere tritt bei der Vernetzungsreaktion keine Blasenbildung auf und es entstehen keine Lösungsmittel. Aufgrund der beschleunigenden Wirkung des Katalysators läuft die Vernetzungsreaktion bereits bei Umgebungstemperatur ab, wobei bei höheren Temperaturen die Reaktionsgeschwindigkeit erhöht bzw. die Reaktionszeit verkürzt werden kann. Bedingt durch die Vernetzung der Polymere wird das ursprünglich flüssige Gemisch der beiden flüssigen Reaktionspartner in einen gelartigen pastösen Zustand übergeführt und dieses die Komponenten der beiden Reaktionspartner (Grundsubstanz, erste Zuschlagssubstanz, zweite Zuschlagssubstanz und die jeweilige dritte Zuschlagssubstanz) enthaltende Materialgemisch als Fügepaste weiter verarbeitet; bsp. kann der pastöse (gelartige) Zustand des Materialgemischs der beiden Reaktionspartner 15 Minuten bis mehrere Stunden aufrechterhalten werden, so daß in dieser Zeitspanne als sogenannte "Topfzeit" eine gute Verarbeitung der Fügepaste möglich ist (diese "Topfzeit" ist die Zeitspanne vom Zeitpunkt zu Beginn der Mischung bis zu dem Zeitpunkt, an dem die Viskosität des Materialgemischs eine noch eine Verarbeitung des Materialgemischs ermöglichende Grenzviskosität erreicht).

Beim Fügen der beiden Fügepartner (Fügeteile) Trägerkörper und Kühlkörper wird die Fügepaste auf eine der beiden Fügeflächen (d.h. auf die Oberfläche eines der beiden Fügepartner) aufgetragen (vorzugsweise auf den Kühlkörper) und die andere Fügefläche (d.h. die Oberfläche des anderen der beiden Fügepartner) nach dem Positionieren der beiden Fügepartner zueinander hiermit in Kontakt gebracht; die Fügepaste kann hierbei auf beliebige (Oberflächen-)Materialien von Kühlkörper und Trägerkörper appliziert werden, bsp. auf metallische, keramische oder polymere Oberflächen, insbesondere kann sie auch zum Fügen einer keramischen Leiterplatte mit einer metallischen Grundplatte herangezogen werden. Bei der mechanischen Verbindung der beiden zueinander positionierten Fügepartner (d.h. unter Druck) zerfließt die Fügepaste (auch bei Umgebungsbedingungen, d.h. bei Umgebungstemperatur), so daß einerseits die zueinander positionierten Oberflächen (Fügeflächen) der beiden Fügepartner vollständig benetzt werden (alle Hohlräume und Unebenheiten werden ausgefüllt, so daß die Fügeflächen hohlraumfrei sind und Rauigkeiten ausgeglichen werden) und andererseits sich an der Oberfläche des Trägerkörpers befindlichen Metallflächen (insbesondere Leiterbahnen und Anschlußflächen einer Leitbahnstruktur oder elektrische Durchkontaktierungen im Trägerkörper) elektrisch isoliert und vor Korrosion geschützt werden. Aufgrund der Viskosität der die Grundsubstanz (vernetztes Polymer), die erste Zuschlagssubstanz (elektrisch isolierende, thermisch leitfähige Partikel), die zweite Zuschlagssubstanz (inkompressible Partikel als Abstandshalter) und die jeweilige dritte Zuschlagssubstanz (Vernetzersubstanz einerseits, Katalysator andererseits) enthaltende, Fügepaste haften die beiden zusammengebrachten Fügepartner (Fügeteile) Trägerkörper und Kühlkörper auch bei Umgebungsbedingungen (bei Umgebungstemperatur) in jeder Lage dauerhaft aneinander (die beiden Fügepartner werden somit in jeder Lage dauerhaft zusammengehalten), da sich insbesondere das vernetzte Polymer als Grundsubstanz der beiden Reaktionspartner und damit die Fügepaste an die Fügeflächen anpaßt und somit die beiden Fügepartner ohne Haftvermittler oder Klebstoffe adhäsiv verbindet. Zur Gewährleistung einer dauerhaften und stabilen Verbindung der beiden miteinander verbundenen Fügepartner (Verbundteile) auch bei erhöhter mechanischer Belastung der elektronischen Baugruppe können die beiden Fügepartner Trägerkörper und Kühlkörper zusätzlich durch Befestigungsmittel miteinander verbunden werden, bsp. miteinander verschraubt werden; über die (bsp. als Schrauben ausgebildete) Befestigungsmittel kann gleichzeitig eine elektrische Verbindung zwischen dem Trägerkörper und dem Kühlkörper realisiert werden.

Nach dem Fügen der beiden Fügepartner wird die Fügepaste zur Bildung der Verbindungsschicht ausgehärtet (dies ist bei Umgebungsbedingungen möglich), wodurch man eine elektrisch isolierende, thermisch leitfähige, eine Mindestdicke gewährleistende, dauerhaft elastische Verbindung der beiden miteinander verbundenen Fügepartner (Verbundteile) in einem großen Temperaturbereich erhält, bsp. im Temperaturbereich von -40°C bis +150°C; die Aushärtezeit beträgt dabei bei Umgebungsbedingungen (bei Umgebungstemperatur) bsp. 1 Stunde bis 10 Stunden, wobei bei höheren Temperaturen die Aushärtezeit verkürzt werden kann (bsp. liegt die Aushärtezeit dann im Minutenbereich).

Der vorzugsweise durch thermische Durchkontaktierungen im Trägerkörper unterstützte Wärmetransport der Verlustleistung der auf der Oberseite des Trägerkörpers (bsp. mittels eines Reflow-Lötprozesses) aufgelöteten Bauteile von der Oberseite des Trägerkörpers zur Unterseite des Trägerkörpers wird die Verlustleistung auf der Unterseite des Trägerkörpers über die Verbindungsschicht auf die gesamte Fläche des Kühlkörpers aufgespreizt und von diesem durch geeignete Maßnahmen (bsp. mittels eines Kühlkreislaufs oder über die zur Verbindung von Kühlkörper und Trägerkörper vorgesehene Befestigungsmittel) an die Umgebung extern abgeführt.

Bei Bedarf können die beiden miteinander verbundenen Fügepartner (Verbundteile) auch nach dem Aushärten der Fügepaste zur Bildung der Verbindungsschicht auf einfache Weise wieder voneinander gelöst werden, insbesondere durch senkrecht auf die Oberfläche eines der beiden Verbundteile Trägerkörper oder Kühlkörper angreifende mechanische Kräfte, bsp. durch senkrechten Zug an der Oberseite der beiden miteinander verbundenen Fügepartner (Verbundteile) oder durch senkrechten Druck auf einen zugänglichen Teilbereich an der Unterseite der beiden miteinander verbundenen Fügepartner (Verbundteile). Die Verbindungsschicht zwischen den beiden miteinander verbundenen Fügepartnern (Verbundteilen) wird hierdurch ohne weiteren Aufwand zerstörungsfrei getrennt (insbesondere ist keine Scherung der beiden Verbundteile erforderlich), so daß die getrennten Fügepartner wiederverwendet werden können, insbesondere da auch das Material der Verbindungsschicht ohne Hilfsstoffe von den Fügeflächen (Oberflächen) der getrennten Fügepartner entfernt werden kann (rückstandsfreie Ablösung der Verbindungsschicht durch Abziehen, Abreiben, Abrubbeln, trockenes Abwischen etc.). Das entfernte Material der Verbindungsschicht stellt keinen Gefahrstoff dar und kann daher problemlos entsorgt werden.

Beim vorgestellten sicheren und einfachen Verfahren zur Herstellung einer elektronischen Baugruppe kann vorteilhafterweise mit geringen Kosten ohne Beeinträchtigung des thermischen Übergangs eine einfache dauerhaft elastische Fügeverbindung der beiden Fügepartner Trägerkörper und Kühlkörper realisiert werden, die ebenso einfach ohne Zerstörung, Beschädigung oder Beeinträchtigung der beiden miteinander verbundenen Fügepartner rückstandsfrei wieder gelöst werden kann. Diese dauerhaft elastische Fügeverbindung zeichnet sich aufgrund des gewählten Materialgemisches der Verbindungsschicht weiterhin durch gute Eigenschaften aus, insbesondere durch vollständige Bedeckung der Fügeflächen der beiden Fügepartner, durch eine gute Wärmeleitfähigkeit zum Abführen bzw. Weiterleiten der Verlustleistung der Bauteile der elektronischen Baugruppe an den Kühlkörper, durch eine gute elektrische Isolation mit ausreichendem Isolationsabstand und durch gute adhäsive Eigenschaften zum Fixieren und Verbinden der beiden Fügepartner.

Das Verfahren soll im folgenden anhand eines Ausführungsbeispiels im Zusammenhang mit der Zeichnung beschrieben werden.
Hierbei zeigt:

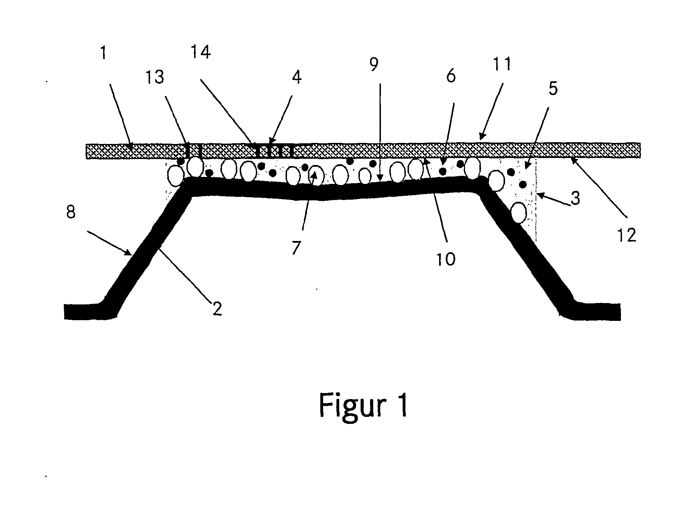

- Figur 1: eine Schnittdarstellung der elektronischen Baugruppe mit einem Ausschnitt der über die Verbindungsschicht verbundenen Fügepartner Trägerkörper und Kühlkörper.

Die auf der Oberseite 11 eines bsp. als Leiterplatte ausgebildeten Trägerkörpers 1 angeordnete Schaltungsanordnung der bsp. als Leistungsmodul eines Kraftfahrzeugs ausgebildeten elektronischen Baugruppe weist neben weiteren aktiven und passiven elektronischen Bauteilen auch mindestens ein Leistungsbauteil auf; die Bauteile der Schaltungsanordnung werden auf die Oberseite 11 (Bestückungsseite) der Leiterplatte 1 bsp. mittels eines Reflow-Lötprozesses aufgelötet und mit Anschlußflächen (Pads) und/oder Leiterbahnen der auf der Leiterplatte 1 aufgebrachten metallischen Leitbahnstruktur 4 kontaktiert. Weiterhin sind elektrische Durchkontaktierungen 13 (elektrische vias) und thermische Durchkontaktierungen 14 (thermische vias) von der Oberseite 11 der Leiterplatte 1 zur Unterseite 1 2 der Leiterplatte 1 vorgesehen; die thermischen Durchkontaktierungen dienen zum vertikalen Abführen der im Betrieb der elektronischen Baugruppe - insbesondere durch die Leistungsbauteile der Schaltungsanordnung - entstehenden Verlustleistung von der Oberseite 11 der Leiterplatte 1 zur Unterseite 12 der Leiterplatte 1. Von der Unterseite 12 der Leiterplatte 1 wird die Verlustleistung mittels des bsp. aus Aluminium bestehenden, bsp. als Kühlblech ausgebildeten metallischen Kühlkörpers 2 an ein Kühlsystem abgeführt. Zwischen der Unterseite 12 der Leiterplatte 1 und dem Kühlblech als Kühlkörper 2 ist zur elektrischen Isolation eine thermisch leitfähige, elektrisch isolierende Verbindungsschicht 3 vorgesehen.

Nach dem Aufbringen und Kontaktieren der Bauteile der Schaltungsanordnung auf die Oberseite 11 der Leiterplatte 1 wird diese Verbindungsschicht 3 durch Aushärten einer auf den Kühlkörper 2 ganzflächig aufgebrachten, mittels der Reaktion zweier getrennt gelagerter flüssiger Reaktionspartner entstehenden Fügepaste gebildet. Der erste Reaktionspartner enthält als Komponenten eine bsp. aus einem unvernetzten Silikon bestehende unvernetzte polymere Grundsubstanz 5, ein bsp. aus einem Gemisch von Al₂O₃ und AIN bestehendes Keramikpulver als erste Zuschlagssubstanz 6 mit einem Anteil im Bereich von bsp. 20% bis 60% und einer Partikelgröße im Bereich von bsp. 1 µm bis 100 µm, bsp. aus Glas bestehende Vollkugeln als zweite Zuschlagssubstanz 7 mit einem Anteil im Bereich von 1 % bis 3% und einem Durchmesser im Bereich von bsp. 100 µm bis 200 µm sowie eine aus Polysiloxanverbindungen bestehende Vernetzersubstanz als dritte Zuschlagssubstanz. Der zweite Reaktionspartner enthält im wesentlichen die gleichen Komponenten wie der erste Reaktionspartner, d.h. eine bsp, aus einem unvernetzten Silikon bestehende polymere Grundsubstanz 5, ein bsp. aus einem Gemisch von Al₂O₃ und AIN bestehendes Keramikpulver als erste Zuschlagssubstanz 6 mit einem Anteil im Bereich von bsp. 20% bis 60% und einer Partikelgröße im Bereich von bsp. 1 µm bis 100 µm, bsp. aus Glas bestehende Vollkugeln als zweite Zuschlagssubstanz 7 mit einem Anteil im Bereich von 1% bis 3% und einem Durchmesser im Bereich von bsp. 100 µm bis 200 µm; abweichend vom ersten Reaktionspartner enthält der zweite Reaktionspartner einen aus Platin bestehenden Katalysator als dritte Zuschlagssubstanz. Bei der Mischung der beiden Reaktionspartner wird durch die jeweilige als Reaktionssubstanz fungierende dritte Zuschlagssubstanz (Vernetzersubstanz einerseits und Katalysator andererseits) eine Polyaddition und damit eine Vernetzung der unvernetzten polymeren Grundsubstanz 5 vorgenommen, wodurch ein gelartiges pastöses Reaktionsprodukt als Fügepaste entsteht; bsp. wird diese Fügepaste durch Mischung der beiden flüssigen Reaktionspartner bei einer Temperatur von 25°C gebildet. Die Fügepaste wird mit einer Schichtdicke von bsp. 250 µm auf die als erste Fügefläche 9 dienende Oberseite 8 des Kühlkörpers 2 ganzflächig aufgebracht (die Schichtdicke der Fügepaste ist damit geringfügig größer als die durch den Durchmesser der inkompressiblen Glaskugeln der zweiten Zuschlagssubstanz 7 als Abstandshalter vorgegebene Mindestschichtdicke) und die als zweite Fügefläche 10 dienende Unterseite 12 der Leiterplatte 1 entsprechend relativ zur ersten Fügefläche 9 positioniert. Die jeweiligen Fügeflächen 9, 10 der beiden Fügepartner Kühlkörper 2 und Leiterplatte 1 werden gegeneinander gedrückt und durch die adhäsive, hohlraumfreie Verbindung der Fügepaste relativ zueinander fixiert; anschließend wird die Fügepaste zur Bildung der Verbindungsschicht 3 ausgehärtet, bsp. 2 Stunden bei einer Temperatur von 25°C. Nach dem Aushärten erhält man über die Verbindungsschicht 3 eine dauerhaft elastische Verbindung der beiden Verbundteile Kühlkörper 2 und Leiterplatte 1; insbesondere beim Einsatz des Leistungsmoduls in einem Kraftfahrzeug und der hiermit einhergehenden mechanischen Belastung können die beiden Verbundteile Kühlkörper 2 und Leiterplatte 1 zusätzlich durch Befestigungsschrauben miteinander verbunden werden können, über die gleichzeitig eine elektrische Verbindung zwischen der Leiterplatte 1 und dem Kühlkörper 2 realisiert wird. Bei Defekten oder beim vorgesehenen Austausch einzelner Bestandteile (Verbundteile) der elektronischen Baugruppe können die beiden Verbundteile Kühlkörper 2 und Leiterplatte 1 durch (senkrechten) Zug von der Oberseite der Leiterplatte 1 her oder durch (senkrechten) Druck auf die Oberseite 8 des Kühlkörpers 2 zerstörungsfrei (ohne Scherkräfte) wieder getrennt werden und die getrennten Fügepartner Kühlkörper 2 und Leiterplatte 1 nach dem (bsp. durch Abwischen erfolgenden) Entfernen der Verbindungsschicht 3 von der Oberfläche der Fügeflächen 9, 10 ggf. weiter verwendet werden.

Die bsp. als Leistungsmodul in einem Kraftfahrzeug eingesetzte elektronische Baugruppe, ist bsp. als Steuergerät für Elektromotoren und Heizung eines Kraftfahrzeugs ausgebildet. Die Schaltungsanordnung des Steuergeräts weist hierzu 16 Bauteile als Leistungsschalter auf; die Verlustleistung der Leistungsschalter von bsp. 25 W wird von der Oberseite 11 der Leiterplatte 1 über die Verbindungsschicht 3 und den Kühlkörper 2 an ein Kühlsystem abgeführt.

## Patentansprüche

1. Elektronische Baugruppe mit mindestens einem auf einem Trägerkörper (1) aufgebrachten Bauteil, und mit einem auf der Unterseite (12) des Trägerkörpers (1) angeordneten Kühlkörper (2) zum Abführen der Verlustleistung des mindestens einen Bauteils,
**dadurch gekennzeichnet,**
**daß** zwischen dem Trägerkörper (1) und dem Kühlkörper (2) eine Fügeverbindung bewirkende, thermisch leitfähige, elektrisch isolierende, dauerhaft elastische Verbindungsschicht (3) aus einem eine vernetzte polymere Grundsubstanz (5) und mindestens zwei Zuschlagssubstanzen (6), (7) enthaltenden Materialgemisch angeordnet ist.

2. Elektronische Baugruppe nach Anspruch 1, **dadurch gekennzeichnet, daß** die Verbindungsschicht (3) als eine erste Zuschlagssubstanz (6) thermisch leitfähige, elektrisch isolierende Partikel und als eine zweite Zuschlagssubstanz (7) inkompressible Partikel enthält.

3. Elektronische Baugruppe nach Anspruch 2, **dadurch gekennzeichnet, daß** die inkompressiblen Partikel der zweiten Zuschlagssubstanz (7) größer als die Partikel der ersten Zuschlagssubstanz (6) sind.

4. Elektronische Baugruppe nach einem der Ansprüche 1 bis 3, **dadurch gekennzeichnet, daß** das Materialgemisch der Verbindungsschicht (3) durch die Reaktion zweier jeweils die unvernetzte polymere Grundsubstanz (5), die erste Zuschlagssubstanz (6), die zweite Zuschlagssubstanz (7) und eine dritte Zuschlagssubstanz als Reaktionssubstanz enthaltenden Reaktionspartner gebildet ist.

5. Elektronische Baugruppe nach Anspruch 4, **dadurch gekennzeichnet, daß** als dritte Zuschlagssubstanz im ersten Reaktionspartner eine die Vernetzung der unvernetzten polymeren Grundsubstanz (5) bewirkende Vernetzersubstanz und im zweiten Reaktionspartner ein die Reaktion der beiden Reaktionspartner aktivierender Katalysator enthalten ist.

6. Elektronische Baugruppe nach Anspruch 4 oder 5, **dadurch gekennzeichnet, daß** die aus der Reaktion der beiden Reaktionspartner entstandene Fügepaste im pastösen Zustand auf den Trägerkörper (1) und/oder den Kühlkörper (2) aufgebracht und zur Bildung der Verbindungsschicht (3) ausgehärtet ist.

7. Elektronische Baugruppe nach einem der Ansprüche 1 bis 6, **dadurch gekennzeichnet, daß** die über die Verbindungsschicht (3) realisierte Fügeverbindung zwischen dem Trägerkörper (1) und dem Kühlkörper (2) durch Druck auf den Trägerkörper (1) oder auf den Kühlkörper (2) oder durch Zug am Trägerkörper (1) oder am Kühlkörper (2) wieder lösbar ist.

8. Elektronische Baugruppe nach einem der Ansprüche 1 bis 7, **dadurch gekennzeichnet, daß** der Trägerkörper (1) mit dem Kühlkörper (2) mittels zusätzlicher Befestigungsmittel verbunden ist.

9. Elektronische Baugruppe nach Anspruch 8, **dadurch gekennzeichnet, daß** durch die Befestigungsmittel eine elektrisch leitende Verbindung zwischen dem Trägerkörper (1) und dem Kühlkörper (2) realisiert ist.

## Claims

1. Electronic assembly with at least one component mounted on a carrier body (1), and with a heat sink (2) for removing the power dissipation of the at least one component, said heat sink (2) being arranged on the bottom (12) of the carrier body (1),
**characterized in that**
a thermally conductive, electrically insulating and permanently flexible connecting layer (3) is arranged between the carrier body (1) and the heat sink (2), said connecting layer (3) achieving a joint and consisting of a material mix that contains a cross-linked polymeric basic material (5) and at least two additional materials (6), (7).

2. Electronic assembly according to claim 1, **characterized in that** the connecting layer (3) contains thermally conductive and electrically insulating particles as a first additional material (6), and incompressible particles as a second additional material (7).

3. Electronic assembly according to claim 2, **characterized in that** the incompressible particles of the second additional material (7) are larger than the particles of the first additional material (6).

4. Electronic assembly according to any one of claims 1 to 3, **characterized in that** the material mix of the connecting layer (3) is formed by the reaction of two reactants that each contain the non-cross-linked polymeric basic material (5), the first additional material (6), the second additional material (7), and a third additional material as a reaction material.

5. Electronic assembly according to claim 4, **characterized in that** the third additional material contained in the first reactant is a cross-linking agent causing the cross-linkage of the non-cross-linked polymeric basic material (5), and the third additional material contained in the second reactant is a catalyst activating the reaction of the two reactants.

6. Electronic assembly according to claim 4 or 5, **characterized in that** the jointing paste resulting from the reaction of the two reactants is applied in its highly viscous state to the carrier body (1) and/or the heat sink (2) and cured for forming the connecting layer (3).

7. Electronic assembly according to any one of claims 1 to 6, **characterized in that** the joint achieved between the carrier body (1) and the heat sink (2) by means of the connecting layer (3) is releasable by applying pressure on the carrier body (1) or on the heat sink (2) or by pulling at the carrier body (1) or at the heat sink (2).

8. Electronic assembly according to any one of claims 1 to 7, **characterized in that** the carrier body (1) is connected to the heat sink (2) by means of additional fastening means.

9. Electronic assembly according to claim 8, **characterized in that** the fastening means achieve an electrically conductive connection between the carrier body (1) and the heat sink (2).

## Revendications

1. Module électronique, ayant au moins un composant placé sur un corps support (1), et ayant un radiateur (2), disposé sur le côté inférieur (12) du corps support (1), pour l'évacuation de la dissipation de puissance du composant au moins au nombre de un,
**caractérisé en ce que**,
entre le corps support (1) et le radiateur (2), il est disposé une couche de connexion (3) provoquant un raccordement par assemblage, thermiquement conductrice, électriquement isolante et durablement élastique, réalisée dans un mélange matériel contenant une substance de base (5) polymère réticulée et au moins deux substances de charge (6), (7).

2. Module électronique selon la revendication 1, **caractérisé en ce que** la couche de connexion (3) contient des particules thermiquement conductrices et électriquement isolantes en tant que première substance de charge (6), et des particules incompressibles en tant que deuxième substance de charge (7).

3. Module électronique selon la revendication 2, **caractérisé en ce que** les particules incompressibles de la deuxième substance de charge (7) sont plus grandes que les particules de la première substance de charge (6).

4. Module électronique selon une des revendications 1 à 3, **caractérisé en ce que** le mélange matériel de la couche de connexion (3) est formé par la réaction de deux partenaires de réaction contenant respectivement la substance de base (5) polymère non réticulée, la première substance de charge (6), la deuxième substance de charge (7) et une troisième substance de charge en tant que substance de réaction.

5. Module électronique selon la revendication 4, **caractérisé en ce que**, en tant que troisième substance de charge, une substance de réticulation provoquant la réticulation de la substance de base (5) polymère non réticulée est contenue dans le premier partenaire de réaction, et un catalyseur activant la réaction des deux partenaires de réaction est contenu dans le deuxième partenaire de réaction.

6. Module électronique selon la revendication 4 ou 5, **caractérisé en ce que** la pâte d'assemblage à l'état pâteux résultant de la réaction des deux partenaires de réaction est appliquée sur le corps support (1) et/ou le radiateur (2), et est durcie pour la formation de la couche de connexion (3).

7. Module électronique selon une des revendications 1 à 6, **caractérisé en ce que** le raccordement par assemblage réalisé via la couche de connexion (3) entre le corps support (1) et le radiateur (2) peut être détachée par pression sur le corps support (1) ou sur le radiateur (2), ou par traction sur le corps support (1) ou sur le radiateur (2).

8. Module électronique selon une des revendications 1 à 7, **caractérisé en ce que** le corps support (1) est raccordé au radiateur (2) au moyen de moyens de fixation supplémentaires.

9. Module électronique selon la revendication 8, **caractérisé en ce que**, sous l'action des moyens de fixation, un raccordement électriquement conducteur est réalisé entre le corps support (1) et le radiateur (2).
